Europäisches Patentamt

European Patent Office

Office européen des brevets

(19)

(11) Numéro de publication: **0 090 714**
**B1**

## (12) FASCICULE DE BREVET EUROPEEN

(45) Date de publication du fascicule du brevet:
29.11.89

(21) Numéro de dépôt: 83400571.2

(22) Date de dépôt: 18.03.83

(51) Int. Cl.⁴: **H 05 K 7/20**

(54) **Système de connexion électrique et d'évacuation de la chaleur par conduction de composants électroniques.**

(30) Priorité: 26.03.82 FR 8205249
26.03.82 FR 8205254

(43) Date de publication de la demande:
05.10.83 Bulletin 83/40

(45) Mention de la délivrance du brevet:
29.11.89 Bulletin 89/48

(84) Etats contractants désignés:
**DE GB IT NL**

(56) Documents cités:
**WO-A-81/03734
DE-A- 2 345 626
FR-A- 2 353 148
FR-A- 2 469 019
GB-A- 1 081 526
US-A- 4 037 270
US-A- 4 093 971
US-A- 4 278 311**

**IBM TECHNICAL DISCLOSURE BULLETIN, vol. 19, no. 8,
jan. 1977, pages 2976-2977, New York, USA; A.H.
BAUMANN et al.: "Multimodule heat sink"
IBM TECHNICAL DISCLOSURE BULLETIN, vol. 13, no. 2,
juillet 1970, page 442, New York, USA; R.J.
DOMBROWSKAS et al.: "Conduction cooled heat plate
for modular circuit package"**

(73) Titulaire: **SOCAPEX, 10 bis, quai Léon Blum,
F-92153 Suresnes (FR)**

(72) Inventeur: **Bricaud, Hervé, THOMSON-CSF SCPI 173, bld
Haussmann, F-75379 Paris Cedex 08 (FR)**

(74) Mandataire: **Hasenrader, Hubert et al, Cabinet BEAU DE
LOMENIE 55, rue d'Amsterdam, F-75008 Paris (FR)**

## Description

La présente invention concerne un système de connexion électrique thermique selon le préambule de la revendication 1.

Les systèmes de connexion électrique qui sont actuellement développés sont notamment destinés à l'interconnexion de circuits intégrés à grande échelle éventuellement disposés dans un boîtier de type «chip-carrier», eux-mêmes reliés à un substrat comportant plusieurs composants de ce type. Ces substrats sont alors reliés à des connecteurs électriques fixés sur une carte mère. La grande densité de ces circuits et leur nombre important sur une surface réduite posent un problème de dissipation de la chaleur engendrée par lesdits circuits. Cette dissipation thermique est généralement réalisée par convection en disposant un radiateur sur la face du substrat opposée à celle où sont disposés les composants.

Un tel système donne satisfaction mais pose quelquefois des problèmes d'encombrement. En effet, la dissipation par convection nécessite l'emploi de radiateurs à grande surface de contact avec l'air ambiant du type profilé d'aluminium muni d'ailettes de refroidissement. Par conséquent, il n'est pas aisé de superposer de façon rapprochée plusieurs substrats et cartes mères dans un même équipement électrique.

Un système de ce type utilisant le refroidissement par convection est décrit dans la demande PCT N° WO 81-03734 publiée le 24 décembre 1981. Dans cette demande, les calories engendrées par le composant sont drainées par conduction jusqu'à un radiateur à ailettes par l'intermédiaire d'une vis, celle-ci étant sur sa face supérieure au contact du composant puis traversant le circuit imprimé et rendue solidaire du radiateur, lequel est lui-même fixé sur la face inférieure dudit circuit imprimé. La dissipation des calories s'effectue alors par convection avec les inconvénients cités ci-dessus. Un tel système, outre les inconvénients cités plus haut, ne peut dissiper une grande quantité de calories du fait que l'élément de conduction thermique est en contact avec des pièces de matière thermo-plastique tels que le boîtier du chip-carrier et traverse le circuit imprimé et la couche isolante disposée entre celui-ci et le radiateur avant d'être rendu solidaire de ce dernier.

Un autre système a été proposé dans le brevet américain 4 037 270. Dans ce système, le chip-carrier en matériau thermo-plastique possède une ouverture dans sa base le traversant de part en part, ouverture dans laquelle vient se loger une conduite forcée de liquide caloporteur, dont une paroi est au contact du composant par l'intermédiaire d'une plaque conductrice de la chaleur. Les calories engendrées par le composant sont donc évacuées par convection forcée. Toutefois, un tel système ne permet pas non plus de connecter des composants du type circuit intégré ou chip-carrier comportant un très grand nombre de sorties par exemple périmétriques, nécessitant alors une connexion électrique sur les quatre côtés du composant. En effet, le système décrit dans ce brevet ne permet la connexion électrique que sur deux côtés du composant compte tenu du fait que les deux autres côtés du boîtier qui le contient sont traversés par la conduite de liquide forcée.

On connaît du document FR-A-2 469 019 un système de connexion électrique et thermique comportant un connecteur de composant à connexions périmétriques, sur lequel est monté le substrat et le composant, ce système comportant un drain thermique et le connecteur ayant dans sa base un logement. La liaison thermique entre le composant et le drain thermique est assurée au moyen d'un conducteur thermique contournant le connecteur, supporté par celui-ci et présentant un trajet de conduction relativement long.

Le système de connexion électrique et thermique selon l'invention permet de résoudre le problème posé, à savoir l'interconnexion électrique et thermique d'un composant comportant des connexions électriques disposées sur son périmètre (micro ou macro-composant à connexions de type périmétrique), et l'évacuation des calories engendrées par ce composant par conduction thermique.

Le système selon l'invention est caractérisé en ce qu'il comprend en outre un radiateur thermique en forme de plaque métallique disposé dans le logement en contact intime avec le composant sur la plus grande surface possible compatible avec les connexions électriques du connecteur et avec le drain thermique solidaire d'un circuit imprimé auquel les connexions électriques du composant sont reliées, le drain thermique étant disposé entre le connecteur et le radiateur d'une part et le circuit imprimé d'autre part. Le drain thermique, solidaire du circuit imprimé, sera constitué par tout moyen ayant une bonne conduction thermique. Si ce moyen est conducteur électrique, on prendra les mesures nécessaires pour isoler celui-ci des connexions électriques du connecteur ainsi que de celles du circuit imprimé. Le drain thermique et son circuit imprimé seront connectés à des moyens de dissipation thermique par l'intermédiaire de glissière thermique, par exemple de la manière décrite dans la demande française 8 205 253 déposée le 26 mars 1982 (correspondant au EP-A-0 090 727) conjointement avec la présente demande et incorporée ici à titre de référence.

Le connecteur pour micro-boîtier ou macro-composant à connexions de type périmétrique peut prendre deux formes distinctes:

— la première forme, en particulier envisageable dans le cas de macro-composants ou de composants spéciaux, est constituée par quatre barrettes de connexions disposées en rectangle. Les moyens de connexion thermique peuvent alors être constitués par une plaque métallique en contact thermique avec les composants d'une part et le drain thermique d'autre part. Cette plaque peut contenir éventuellement des alvéoles dans lesquelles viennent se loger les composants, la jonction thermique entre les deux étant encore améliorée par la présence de joints thermiques connus en soi. Afin d'améliorer encore l'évacuation des calories dissipées, l'épaisseur de cette plaque sera sensiblement égale à la distance entre le substrat et le drain thermique avec des alvéoles aux endroits correspondant aux composants, le contact thermique étant ainsi assuré entre le substrat et le drain thermique d'une part et les composants et le drain thermique d'autre part, tandis que le maintien du substrat par les connecteurs en vis-à-vis assure un maintien efficace de ces moyens de conduction. Elle contribue à amortir les oscillations de la carte en cas de vibrations et évite ainsi la rupture du substrat si celui-ci est en alumine. Dans le cas où l'on désire assurer encore une meilleure solidarisation de ces moyens de conduction et du drain thermique, des moyens de fixation de ces deux éléments sont par ailleurs prévus.

Dans la seconde variante, le connecteur est du type monobloc de forme rectangulaire ou carré, comportant une ouverture dans sa base de dimension plus réduite que l'ouverture supérieure correspondant au micro-composant à connecter, de manière à ménager des épaulements sur lesquels viennent s'appuyer les moyens de conduction sous la forme d'une simple plaque métallique, de préférence solidarisée avec le drain thermique par l'intermédiaire d'une vis qui réalise ainsi la fixation mécanique du boîtier sur le circuit permettant ensuite des manipulations aisées de l'ensemble même avant soudure des connexions électriques sur le circuit imprimé. De plus, dans cette seconde variante de l'invention, le micro-boîtier comporte des moyens de pression sur le composant électrique de manière à assurer un meilleur contact thermique entre celui-ci et les moyens de conduction thermique disposés sous celui-ci. Ces moyens de pression seront par exemple des moyens élastiques disposés dans le capot du boîtier qui vient se fermer au-dessus du composant après introduction de celui-ci.

L'invention sera mieux comprise à l'aide des exemples de réalisation, donnés à titre non limitatif, conjointement avec les figures qui représentent:

- la figure 1, une vue de dessus d'un connecteur utilisable dans le système selon l'invention,

- la figure 2, une vue de côté du connecteur de la figure 1,

- la figure 3, une vue en coupe de l'embase du connecteur de la figure 1 au niveau des contacts électriques de celle-ci,

- la figure 4, en vue de dessus et différentes vues latérale et en coupe du capot du connecteur de la figure 1,

- la figure 5, le connecteur selon l'invention muni d'un radiateur de refroidissement par conduction,

- la figure 6, une vue en coupe d'un système selon l'invention,

- la figure 7, un exemple de réalisation de moyens de conduction thermique selon l'invention.

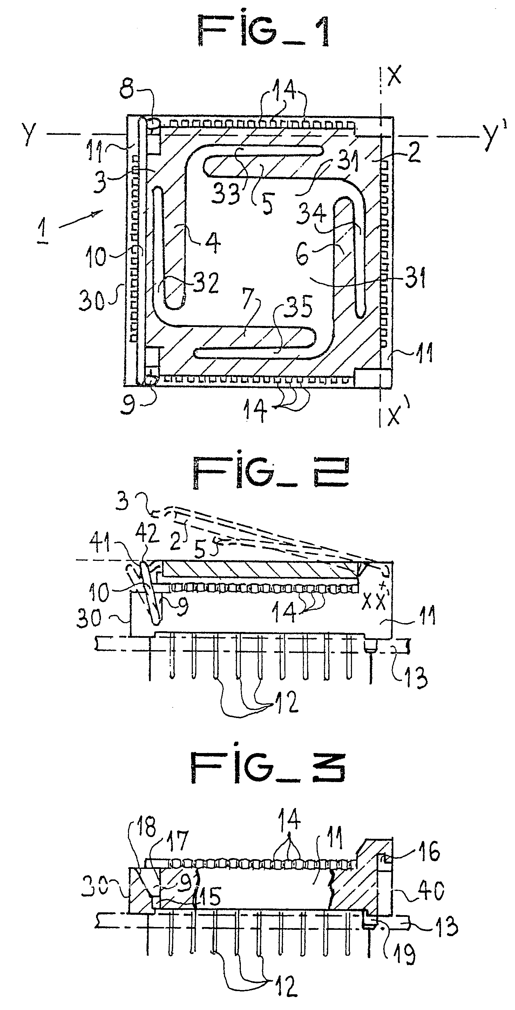

Sur la figure 1, est représentée schématiquement une vue de dessus d'un connecteur utilisable dans un système selon l'invention. Ce connecteur 1 comporte essentiellement une embase 11 revêtue d'un capot 2 pivotant autour de l'axe XX' commun au capot et à l'embase. Cette embase comporte sur toute sa périphérie une pluralité de contacts électriques 14 (de préférence souples dans le sens vertical sur la figure) destinés dans leur prolongement interne à être au contact des connexions périmétriques du chip-carrier. Le capot 2 comporte essentiellement quatre doigts 4, 5, 6 et 7 ayant une fonction de ressort, découpés dans le capot dont la partie centrale 31 est évidée. Chaque doigt 4, 5, 6 et 7 est donc séparé de la partie périmétrique du capot par un espace tel que 32, 33, 34, 35. Ce capot se prolonge à l'opposé de l'axe XX' par une partie continue 3 portant un épaulement sur lequel vient s'appuyer un collier 10. Ce collier 10 est parallèle au capot et à l'embase sensiblement sur toute sa longueur et vient se loger à ses extrémités dans des logements appropriés 8 et 9.

La figure 2 montre une vue latérale du connecteur de la figure 1 avec en traits pleins le capot en position fermée et verrouillée par le collier 10 et en traits pointillés le capot en position ouverte. Sur cette figure, les mêmes éléments que ceux de la figure précédente portent les mêmes références. Ainsi qu'on peut le constater, en position ouverte du capot 2, le doigt 5 se trouve en dessous du plan du capot 2 de manière à exercer une pression sur le chip-carrier (non représenté sur la figure) lors de la fermeture de celui-ci. On remarque également le logement 9 de forme conique du collier 10 ainsi que la position ouverte (déverrouillage) dudit collier 10 dans laquelle l'extrémité de ce collier est sensiblement à l'aplomb de la face latérale 30 de l'embase 11. On constate ainsi de cette manière que le connecteur selon l'invention a une structure lui permettant non seulement de prendre peu de place mais que celle-ci permet l'ouverture dudit connecteur dans tous les cas, même lorsqu'un autre boîtier ou une paroi se trouvent contre la face latérale 30 dudit connecteur.

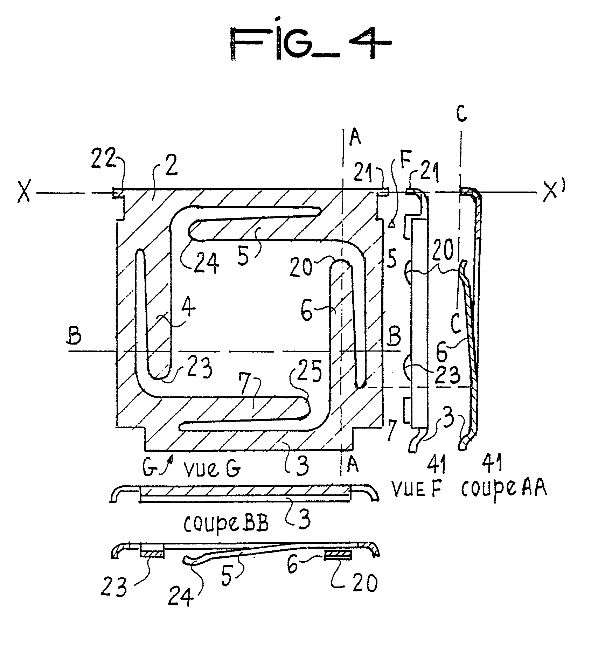

Sur la figure 3, est représentée une vue en coupe suivant l'axe YY' du connecteur de la figure 1. Les mêmes éléments que ceux des figures précédentes portent les mêmes références. Le connecteur a été représenté fixé sur une carte imprimée 13, les contacts électriques 12 prolongeant les contacts électriques 14 traversant ledit circuit imprimé. Le repérage du boîtier s'effectue à l'aide d'un repère tel que 19. L'embase 11 ainsi représentée présente un certain nombre de particularités. Du côté de sa face latérale 40 se trouve un logement 16 dans lequel vient se loger le picot 22 (figure 4) de manière à créer le pivotement du capot 2. A proximité du flanc latéral 30, se trouve le logement 9 qui guide le collier 10 lorsque celui-ci bascule d'une position de verrouillage à une position de déverrouillage ou vice versa. Le côté 17 de ce logement est sensiblement vertical de manière à réaliser une butée empêchant le collier de recouvrir le capot. Le côté 18 de ce logement 9 est incliné de telle sorte que l'extrémité 41 du capot 2 puisse être dégagée du collier lorsque celui-ci vient en butée contre cette paroi 18 avec toutefois un angle suffisamment faible pour éviter au collier de dépasser sensiblement l'aplomb de la face latérale 30 de l'embase 11. La base du logement 9 comporte une ouverture 15 dans laquelle vient s'enfoncer l'extrémité du collier 10. On remarque par ailleurs (figure 2) que la hauteur du collier 10 et l'épaulement à l'extrémité 3 du capot 2 sont tels que ledit collier arrive sensiblement au niveau supérieur du capot en son point 42 lorsque le capot est en position fermée. Par ailleurs, comme représenté sur la figure 2, l'épaulement 3 est constitué par un cambrage du capot 2 sensiblement à 90° vers le bas de la figure puis un nouveau cambrage à 90° en sens inverse de manière à amener l'extrémité 41 de l'épaulement 3 parallèle à la partie supérieure du capot 2. Les différents plis renforcent la rigidité du capot qui peut être réalisé en tôle de faible épaisseur.

Sur la figure 4, est représentée une vue détaillée et différentes coupes du capot 2, figure sur laquelle les mêmes éléments que ceux des figures précédentes portent les mêmes références. Ce capot est de forme sensiblement carrée et comporte deux ergots 21 et 22 selon l'axe XX' destinés à coopérer avec un logement tel que 16 (figure 3). Les différentes vues sur les faces F et G d'une part et les coupes AA et BB d'autre part montrent clairement la structure explicitée ci-avant. On remarquera toutefois que, en position de repos, le bossage 20 situé à l'extrémité du doigt 6 (ainsi que les bossages 24 pour le doigt 5, 23 pour le doigt 4, 25 pour le doigt 7) est aligné avec l'extrémité recourbée à 90° du capot 2 le long de l'axe XX', ce bossage 20 et cette extrémité se trouvant sur l'axe CC.

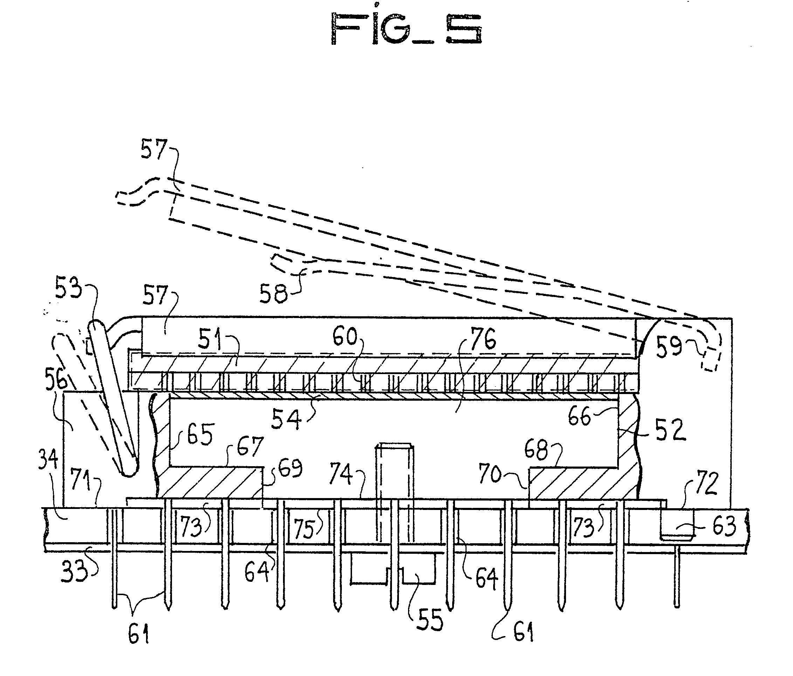

Sur la figure 5, est représentée une variante de la figure 2 du boîtier selon l'invention, prévue pour l'incorporation d'un radiateur de refroidissement par conduction. Le micro-boîtier ou chip-carrier 51 est placé dans l'embase 56 de manière à réaliser un contact électrique entre ses connexions périmétriques et les contacts tels que 60 de l'embase reliés aux contacts extérieurs tels que 61. Le capot de fermeture 57 muni des moyens élastiques 58 tels que décrits précédemment pivote autour de l'axe 59 et, lesdits moyens élastiques 58 pressent le chip-carrier contre les contacts électriques de l'embase, un collier de fermeture 53 venant verrouiller l'extrémité 62 du capot 57 comme expliqué précédemment. L'embase 56 de forme sensiblement carrée comporte donc des contacts électriques souples 60 disposés sur sa périphérie interne. Les contacts correspondants 61 viennent se connecter sur le circuit imprimé 33 solidaire d'un drain thermique 34 ayant de bonnes propriétés de conduction thermique. Le positionnement du boîtier se fait facilement à l'aide de deux ergots tels que 63 qui viennent se loger dans les trous correspondants du drain thermique. Les passages tels que 64 des contacts 61 à travers le drain thermique sont suffisamment larges pour éviter un contact avec ce drain et peuvent être éventuellement isolés lorsque ce drain est un conducteur électrique (il s'agit généralement d'un métal tel que l'aluminium, le cuivre ou l'acier, revêtu d'une couche électriquement isolante si nécessaire). L'embase 56 comporte sur sa partie inférieure interne un logement 52 destiné à recevoir un radiateur 76 pour évacuer par conduction thermique les calories dissipées par les composants du chip-carrier en direction du drain thermique 34. Ce logement est bien entendu de largeur inférieure à la largeur correspondante du chip-carrier, ses dimensions étant au plus égales aux dimensions séparant deux rangées opposées de contact disposées à la périphérie du chip-carrier. Ce logement 52 comporte des parois verticales 65, 66 environ sur les deux tiers de la hauteur de l'embase 56, ces parois se prolongeant par des parois horizontales 67, 68 qui convergent l'une vers l'autre, destinées à soutenir le radiateur 76, chacune d'entre elles se prolongeant à nouveau par une paroi verticale 69, 70 créant une ouverture dans la partie inférieure de l'embase 56. Celle-ci repose sur le circuit par ses bords 71, 72 tandis qu'à son centre un espacement 73 est prévu entre elle et le drain thermique 34 qui la supporte permettant le lavage du flux de soudure. L'ouverture inférieure de l'embase 56 est donc située, en coupe, le long de la ligne 74, tandis que le radiateur, qui vient se loger dans le logement 52 se prolongera bien entendu jusqu'à la ligne de contact 75, c'est-à-dire au même niveau que les bords 71 et 72, ceci de manière à être en contact avec le drain thermique 34 lors de l'utilisation du boîtier. Une vis de serrage 55 est même prévue sensiblement au milieu du radiateur de manière à fixer en contact thermique étroit le drain thermique 34 et le radiateur le long de la surface de séparation 75, si cela s'avère nécessaire. De cette manière, on peut ainsi solidariser l'embase 56 du drain thermique avant soudure des contacts électriques 61.

Afin d'assurer une meilleure conduction thermique, on interposera généralement un joint thermique 54 constitué d'une pâte de conduction thermique connue en soi entre le chip-carrier 51 et le radiateur 76 logé dans l'emplacement 52. Ce joint thermique, outre une meilleure conduction thermique assurera également une fonction de joint mécanique du fait de la pression exercée par les doigts 58 sur le chip-carrier 51. Le même joint thermique peut être incorporé entre le radiateur 76 et le drain thermique 34. Ce joint thermique est une pâte à base de silicones telle que celles vendues sous la marque RHODORSIL par la Société RHONE POULENC.

On constate ainsi que le connecteur selon cette variante de l'invention assure par ses moyens élastiques 58 une pression du chip-carrier d'une part sur les contacts électriques souples de l'embase de manière à obtenir un bon contact électrique et d'autre part entre la partie centrale de celui-ci située entre les contacts périmétriques et le drain thermique 34 par l'intermédiaire du joint thermique 54, et du radiateur 76 qui est ainsi plaqué sur le drain thermique 34.

Le système de connexion électrique et thermique décrit notamment à l'aide de la figure 5 donne en pratique d'excellents résultats en particulier du

point de vue thermique, permettant un fonctionnement plus sur des micro-boîtiers utilisés.

Sur la figure 6, une carte mère 101 constituée d'un circuit imprimé 133 et d'un drain thermique 134 supporte deux barrettes de connexion électriques 135 et 136. Les contacts électriques 103, 105 de ces barrettes sont reliés électriquement au circuit imprimé 133 d'une part ainsi qu'au substrat 106, dans la zone des extrémités de contact de celui-ci (non représenté sur la figure). Chaque barrette comporte une embase 102 et un capot 104 solidaires l'un de l'autre par rotation autour d'un axe 109. Entre capot et embase, vient se loger le substrat 106 qui s'appuie sur l'extrémité des contacts 103 et 105 et sur lequel la face opposée duquel repose les capots 104. Deux circuits du type «chip-carrier» 141, 131 sont fixés sur le substrat 106 de manière habituelle par soudure des connexions issues de ces micro-boîtiers sur les connexions électriques correspondantes du substrat.

Ces boîtiers sont situés sur la face inférieure du substrat et sont logés dans des alvéoles 151, 152 d'un dispositif 142 de conduction thermique ci-après dénommée radiateur. Un joint thermique 144 assure le contact thermique entre le radiateur 142 et les boîtiers 131, 141 ainsi que entre le substrat 106 et le radiateur dans les zones telles que 153, 154 ou 155 situées à l'extérieur des composants. Le radiateur 142 est par ailleurs en contact thermique avec le drain thermique 134. Des vis de fixation 145 sont prévues de manière à solidariser efficacement le radiateur et le drain thermique et assurer ainsi encore un meilleur contact thermique. Ainsi qu'on peut le noter sur la figure, la hauteur du radiateur dans les zones ne comportant pas d'alvéoles telles que 151 ou 152 est sensiblement égale à la distance entre le substrat 106 et le drain thermique 134. On note également des espaces 156, 157 latéraux entre le rebord des barrettes de connection 135, 136 et les flancs latéraux correspondant du radiateur 142. Bien entendu, le substrat 106 peut comporter quatre barrettes de connection disposées sur ses quatre côtés.

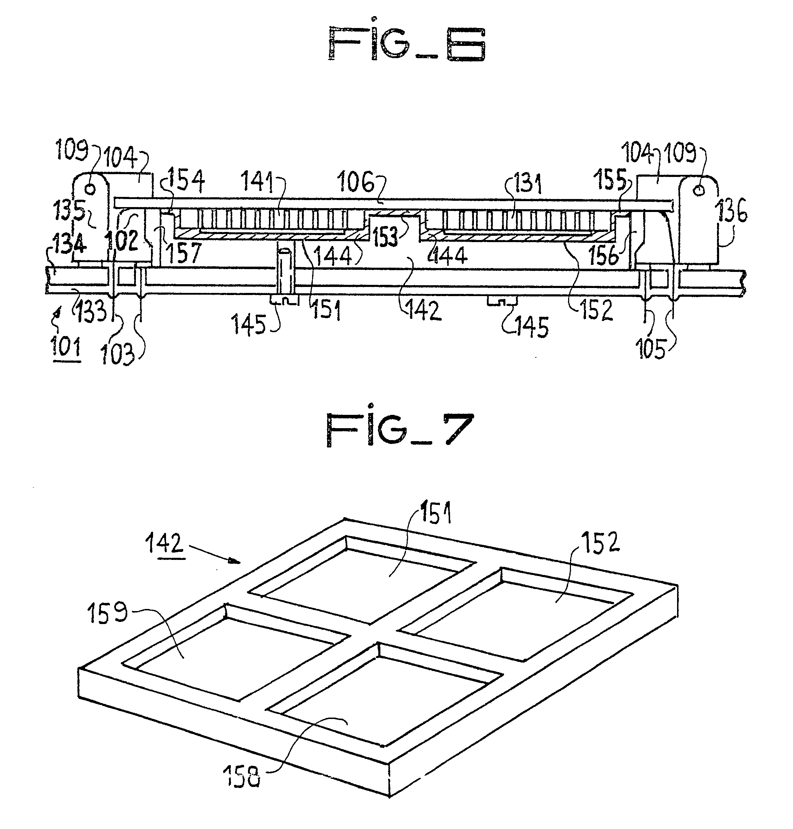

La figure 7 représente une vue en perspective du radiateur 142 de la figure 6. Ce radiateur 142 comporte ici quatre alvéoles 151, 152, 158 et 159 destinées à recevoir des chip-carriers tel qu'expliqué ci-dessus. Il est réalisé par usinage d'une plaque métallique par exemple d'aluminium dans laquelle on usine les quatre alvéoles.

## Revendications

1. Système de connexion électrique et thermique pour composant à connexions périmétriques, le système comportant au moins un composant électronique (51, 131, 141) fixé à un substrat; un drain thermique (34, 134) et un connecteur de composant à connexions périmétriques, le connecteur ayant dans sa base un logement (52); le système étant caractérisé en ce qu'il comprend en outre un radiateur thermique en forme de plaque métallique disposé dans le logement en contact intime avec le composant sur la plus grande surface possible compatible avec les connexions électriques du connecteur et avec le drain thermique solidaire d'un circuit imprimé auquel les connexions électriques du composant sont reliées, le drain thermique étant disposé entre le connecteur et le radiateur d'une part et le circuit imprimé d'autre part.

2. Système de connexion électrique et thermique selon la revendication 1, caractérisé en ce que le connecteur est constitué par quatre barrettes de connexion situées en vis-à-vis supportant ledit substrat sur lequel est fixé ledit composant de manière à être en contact avec le radiateur.

3. Système de connexion électrique et thermique selon la revendication 1, caractérisé en ce que le connecteur est du type monobloc et comporte dans sa base une ouverture de dimension plus réduite que l'ouverture supérieure correspondant au composant à connecter.

4. Système de connexion électrique et thermique selon la revendication 2, caractérisé en ce que le radiateur est constitué par une plaque métallique comportant des alvéoles de forme complémentaire à celle du ou des composants situés sur le substrat.

5. Système de connexion électrique et thermique selon l'une quelconque des revendications 1 à 4, caractérisé en ce qu'un joint thermique est interposé entre le ou les composants et le radiateur.

## Claims

1. Thermal and electrical connection system for a component having peripheral connections, the system comprising at least one electronic component (51, 131, 141) fixed on a substrate; a thermal drain (34, 134) and a connector for a component with peripheral connections, the connector comprising in its base a housing (52); the system being characterized in that it further comprises a thermal radiator in the form of a metal plate, placed inside a housing in close contact with the component over the largest surface possible compatible with the electrical connections of the connector and with the thermal drain fast with a printed circuit to which the electrical connections of the component are coupled, the thermal drain being placed between the connector and the radiator, on the one hand, and between the connector and the printed circuit, on the other hand.

2. Thermal and electrical connection system according to claim 1, characterized in that the connector is composed of four connecting strips situated in mutal facing relationship and supporting said substrate on which said component is fixed in such a way as to be in contact with the radiator.

3. Thermal and electrical connection system according to claim 1, characterized in that the connector is of monobloc type and comprises in its base an opening of smaller dimension than the upper opening corresponding to the component to be connected.

4. Thermal and electrical connection system according to claim 2, characterized in that the radiator is constituted by a metal plate provided with cells of shape complementary to that of the component or components situated on the substrate.

5. Thermal and electrical connection system according to any one of claims 1 to 4, characterized in that a heat seal is interposed between the component or components and the radiator.

**Patentansprüche**

1. System zur elektrischen und thermischen Verbindung für ein Bauelement mit Verbindungselementen an seinem Umfang, wobei das System wenigstens ein an einem Substrat befestigtes elektronisches Bauelement (51, 131, 141), eine Wärmesenke (34, 134) und einen Bauelementverbinder mit Verbindungselementen an seinem Umfang aufweist und der Verbinder in seinem Grundkörper eine Kammer (52) enthält, gekennzeichnet durch einen Wärmeableiter in Form einer Metallplatte, der in der Kammer angeordnet ist, der mit dem Bauelement auf einer möglichst grossen Oberfläche in innigem Kontakt steht und an die elektrischen Verbindungselemente des Verbinders sowie an die Wärmesenke angepasst ist, die einheitlich mit einer gedruckten Schaltung ist, mit der die elektrischen Verbindungselemente des Bauelements verbunden sind, wobei die Wärmesenke zwischen dem Verbinder und dem Wärmeableiter einerseits und zwischen dem Verbinder und der gedruckten Schaltung andererseits angeordnet ist.

2. System zur elektrischen und thermischen Verbindung nach Anspruch 1, dadurch gekennzeichnet, dass der Verbinder vier einander gegenüber angeordnete Verbindungsstege aufweist, die das Substrat tragen, auf dem das Bauelement derart fixiert ist, dass es mit dem Wärmeableiter in Kontakt steht.

3. System zur elektrischen und thermischen Verbindung nach Anspruch 1, dadurch gekennzeichnet, dass der Verbinder ein Monoblock-Verbinder ist und in seiner Grundplatte eine Offnung aufweist, die kleiner als die obere Offnung entsprechend dem zu verbindenden Bauelement ist.

4. System zur elektrischen und thermischen Verbindung nach Anspruch 2, dadurch gekennzeichnet, dass der Wärmeableiter aus einer Metallplatte besteht, die Zellen in einer Form aufweist, bzw. welche auf dem Substrat angeordnet sind.

5. System zur elektrischen und thermischen Verbindung nach einem der Ansprüche 1 bis 4, dadurch gekennzeichnet, dass eine Wärmeverbindung zwischen dem oder den Bauelementen und dem Wärmeableiter vorgesehen ist.

# FIG_1

# FIG_2

# FIG_3

# FIG_4

FIG_5

# FiG_6

# FiG_7